(19) Europäisches Patentamt
European Patent Office
Office européen des brevets

(11) **EP 4 142 449 B1**

## (12) FASCICULE DE BREVET EUROPEEN

(45) Date de publication et mention
de la délivrance du brevet:
**03.09.2025 Bulletin 2025/36**

(21) Numéro de dépôt: **22188653.4**

(22) Date de dépôt: **04.08.2022**

(51) Classification Internationale des Brevets (IPC):
***H05K 9/00*** *(2006.01)*

(52) Classification Coopérative des Brevets (CPC):
**H05K 9/0088**

---

(54) **DISPOSITIF D'ABSORPTION D'ONDE ÉLECTROMAGNÉTIQUE**

VORRICHTUNG ZUR ABSORPTION EINER ELEKTROMAGNETISCHEN WELLE

DEVICE FOR ABSORBING ELECTROMAGNETIC WAVES

---

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.08.2021 FR 2108795**

(43) Date de publication de la demande:
**01.03.2023 Bulletin 2023/09**

(73) Titulaire: **THALES**
**92190 Meudon (FR)**

(72) Inventeurs:
• **VANDELLE, Erika**
**91120 PALAISEAU (FR)**
• **HOANG, Thi Quynh Van**
**91120 PALAISEAU (FR)**

(74) Mandataire: **Atout PI Laplace**
**Immeuble Up On**
**25 Boulevard Romain Rolland**
**CS 40072**
**75685 Paris Cedex 14 (FR)**

(56) Documents cités:
**CN-A- 111 403 536     CN-A- 112 397 906**

• **REN JIAN ET AL: "3D-Printed Low-Cost Dielectric-Resonator-Based Ultra-Broadband Microwave Absorber Using Carbon-Loaded Acrylonitrile Butadiene Styrene Polymer", MATERIALS, vol. 11, no. 7, 1 July 2018 (2018-07-01), CH, pages 1249, XP055831380, ISSN: 1996-1944, DOI: 10.3390/ma11071249**
• **VAN HOANG THI QUYNH ET AL: "Ultra-broadband Multilayer Microwave Absorber by Multimaterial 3D Printing", 2020 14TH EUROPEAN CONFERENCE ON ANTENNAS AND PROPAGATION (EUCAP), EURAAP, 15 March 2020 (2020-03-15), pages 1 - 4, XP033788859, DOI: 10.23919/EUCAP48036.2020.9135371**

**Description**

**DOMAINE DE L'INVENTION**

La présente invention concerne l'absorption ou l'atténuation de rayonnement électromagnétique avec des matériaux structurés. On s'intéresse particulièrement à l'absorption des ondes dans la bande 0.1 GHz - 50 GHz, qui inclut les bandes L, S, C, X, Ku, K, Ka.

**ETAT DE LA TECHNIQUE**

Les absorbants d'ondes électromagnétiques trouvent leur place dans un large spectre d'applications. On les trouve dans les chambres anéchoïques pour supprimer les interférences lors de la caractérisation d'antennes. Les absorbants peuvent également être déployés sur tout objet métallique pour supprimer les interférences proches de systèmes radars ou de télécommunications (découplage). Enfin, les absorbants sont aussi présents dans les systèmes antennaires pour plusieurs raisons : le découplage entre éléments, la réduction des rayonnements latéraux et arrière, et surtout, l'adaptation antenne - structure qui conduit à la réduction des lobes secondaires. Ainsi les absorbants trouvent à s'intégrer dans des équipements radar, des équipements antennaires de télécommunication (par exemple sur des plateformes en mouvement) ou des équipements de caractérisation antennaires.

Dans un système antennaire, un absorbant peut servir à :

découpler plusieurs éléments rayonnants

supprimer les rayonnements arrière ou latéraux

adapter l'antenne à la structure pour réduire les lobes secondaires

Dans un système de caractérisation antennaire, les absorbants permettent :

de supprimer les interférences dans la chambre anéchoïque

de masquer des systèmes métalliques proches des systèmes à caractériser

Pour répondre aux différents besoins, un absorbant doit être :

- large bande (pour couvrir le plus de bandes de fréquence possible)

- insensible à la polarisation de l'onde incidente

- robuste en angle d'incidence oblique (nécessité de fonctionner pour les ondes rasantes)

La robustesse angulaire se mesure par rapport à l'angle maximum pour une onde incidente (en mode Transverse Electrique (TE) ou Transverse Magnétique (TM) par rapport à la surface de l'absorbant), donné ici par rapport à la normale à cette surface, pour lequel le niveau d'absorption est supérieur à un niveau donné (on considère par exemple 90%). Un des enjeux majeurs aujourd'hui est d'améliorer la robustesse angulaire d'absorbants large bande tout en maintenant une épaisseur raisonnable. De plus, pour la plupart des applications en extérieur, les absorbants doivent avoir une haute tenue thermo-mécanique.

Récemment des absorbants structurés ont été développés. On y retrouve des solutions planaires ou multicouches (solutions dite hybrides) de type Métal-Isolant-Métal (MIM) ou des solutions impliquant la structuration de matériaux diélectriques ou magnéto-diélectriques, qui permettent d'obtenir des épaisseurs raisonnables. Les solutions hybrides sont assez peu robustes en incidence oblique et leur fabrication complexe due à l'alternance des matériaux ne permet pas, notamment pour les MIM multicouches, l'exploration de nouvelles formes pour l'amélioration des performances en incidence oblique. Les structures diélectriques ou magnéto-diélectriques sont des solutions généralement mono-matériau qui permettent d'obtenir des hautes performances hyperfréquences en alliant le choix du matériau et celui de la structuration.

On dénomme matériau diélectrique un matériau présentant une permittivité $\varepsilon$ définie par : $\varepsilon = \varepsilon' + i\varepsilon''$ et une perméabilité égale à 1. Soit avec $\mu = \mu' + i\mu''$ on a $\mu' = 1$ et $\mu'' = 0$.

On dénomme matériau magnéto-diélectrique un matériau qui présente une perméabilité telle que $\mu'$ différent de 1 et/ou $\mu''$ différent de 0.

Les structures diélectriques ou magnéto-diélectriques sont réalisées avec des matériaux qui ont généralement une forte permittivité et/ou perméabilité, une grande dispersion en fréquence ainsi que de fortes pertes diélectriques, avec des effets de diffraction des bords et des résonances multiples lorsque plusieurs couches sont implémentées.

On définit les pertes diélectriques comme le ratio $\varepsilon''/\varepsilon'$ et les pertes magnétiques comme le ratio $\mu''/\mu'$.

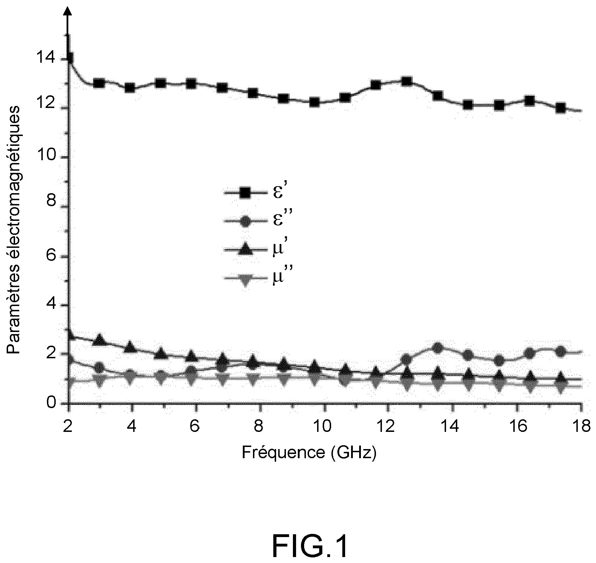

Selon un premier exemple la publication D. Zhou et al, "Analysis and Design of Multilayered Broadband Radar Absorbing Metamaterial Using the 3-D Printing Technology-Based Method," IEEE Antennas and Wireless Propagation Letters, 16, 133-136, 2017 décrit une structure multicouche avec des résonateurs rectangulaires. Cette structure est imprimée par la méthode de frittage sélectif par laser (SLS en anglais) avec un composite de nylon et de la poudre de fer carbonyle. Les paramètres électromagnétiques ($\varepsilon'$, $\varepsilon''$, $\mu'$, $\mu''$) de ce matériau en fonction de la fréquence f sont donnés figure 1. La structure montre une absorption supérieure à 90% sur une large bande de fréquence de 8 à 18 GHz pour une épaisseur de 3 mm. Aucun résultat n'est donné en incidence oblique.

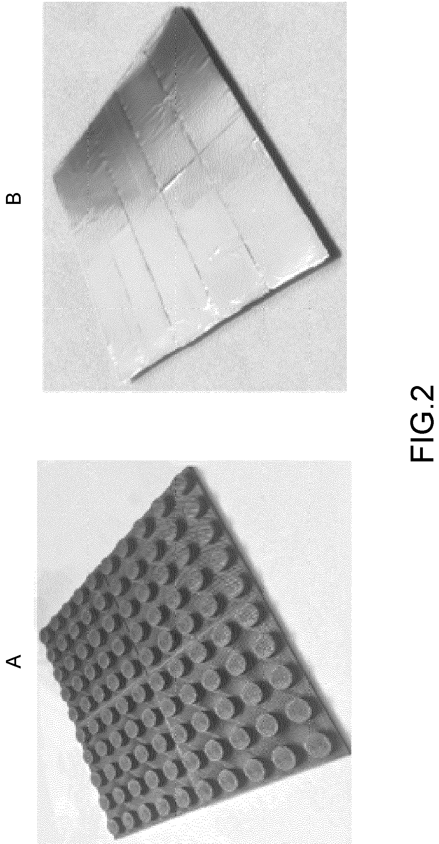

Selon un deuxième exemple la publication J. Ren et al "3D-Printed Low-Cost Dielectric-Resonator-Based Ultra-Broadband Microwave Absorber Using Carbon-Loaded Acrylonitrile Butadiene Styrene Polymer," Materials, 11, 1249, 2018 décrit des résonateurs cylindriques en ABS chargé de carbone (matériau diélectrique), tels qu'illustré figure 2. Côté gauche (A) est présentée la vue du côté des cylindres et le côté droit (B) présente la vue côté substrat métallique. La fréquence de résonnance est fonction de la permittivité $\varepsilon$ (typiquement en $1/\sqrt{\varepsilon}$ d'après la résolution de l'équation caractéristique du mode résonant), ce qui permet d'exciter des modes de résonnance sur plusieurs fréquences et d'obtenir une large bande. Cette structure montre une absorption supérieure à 90% sur une large bande allant de 4 à 12 GHz et une robustesse angulaire jusqu'à 45° pour les modes TE et pour une épaisseur de 10 mm.

Ainsi les absorbants à base de matériaux diélectriques ou magnéto-diélectriques structurés tirent profit à la fois des propriétés électromagnétiques des matériaux, qui ont généralement une forte permittivité et/ou perméabilité ainsi qu'une grande dispersion en fréquence intrinsèque, et de la structuration 3D pour atteindre une robustesse angulaire importante. Ils ont l'avantage d'être insensibles à la polarisation et facilement large bande grâce à l'exploitation des propriétés de matériaux artificiels. La méthode additive semble une méthode propice à l'industrialisation, ce qui limite le spectre de matériaux utilisables.

Cependant, peu de formes 3D ont été proposées pour adresser la problématique de la robustesse angulaire. Des structurations pyramidales ont été proposées mais l'épaisseur des absorbants est généralement grande. Dans les structures basées sur des résonateurs, des formes de résonateurs rectangulaires ou cylindriques ont été décrites, ce qui offre une robustesse angulaire raisonnable mais qui peut être améliorée.

Le document CN111403536 décrit un absorbant pour une lumière présentant une longueur d'onde comprise entre 280 nlm et 4000 nm, constitué de sphères jointives et selon un empilement multicouches.

Un but de la présente invention est de remédier aux inconvénients précités en proposant un dispositif d'absorption d'ondes électromagnétiques comprenant un réseau bidimensionnel de résonateurs en matériau diélectrique ou magnéto diélectrique présentant une forme de calotte sphérique, ce qui conduit à des performances angulaires améliorées.

## DESCRIPTION DE L'INVENTION

La présente invention a pour objet un dispositif d'absorption d'ondes électromagnétiques comprenant un réseau bidimensionnel de résonateurs en un premier matériau diélectrique ou magnéto diélectrique, lesdits résonateurs présentant une forme de calotte sphérique, les ondes électromagnétiques à absorber étant comprises entre 0.1 et 50 GHz.

Selon un mode de réalisation le réseau bidimensionnel est selon deux axes X et Y perpendiculaires entre eux et la périodicité selon X est égale à la périodicité selon Y.

Selon un mode de réalisation le premier matériau est une matrice thermoplastique chargée magnétiquement.

Selon un mode de réalisation le premier matériau présente un niveau de perte $1/Q_0$ inférieur ou égal à 0.05, pour une bande de fréquence [2 GHz; 18 GHz], avec :

$$Q_o = \frac{1}{tan\delta_d} + \frac{1}{tan\delta_m}$$

| | |
|---|---|
| $tan\delta_d = \varepsilon''/\varepsilon'$ | pertes diélectriques |
| $tan\delta_m = \mu''/\mu'$ | pertes magnétiques |
| $\varepsilon = \varepsilon' + i\varepsilon''$ | $\varepsilon$ permittivité du premier matériau |
| $\mu = \mu' + i\mu''$ | $\mu$ perméabilité du premier matériau |

EP 4 142 449 B1

Selon un mode de réalisation les ondes électromagnétiques à absorber sont comprises dans la bande [2 GHz ; 18 GHz].

Selon un mode de réalisation la calotte sphérique est un hémisphère.

Selon un mode de réalisation les résonateurs sont reliés entre eux par une portion de couche ou une couche en premier matériau.

Selon un mode de réalisation les résonateurs sont disposés sur une couche en deuxième matériau.

Selon un mode de réalisation le deuxième matériau est choisi parmi : un matériau métallique, un matériau diélectrique, un matériau magnéto diélectrique.

Selon un mode de réalisation le deuxième matériau est un élastomère chargé magnétiquement.

Selon un autre aspect l'invention concerne un procédé de fabrication d'un dispositif d'absorption d'ondes électromagnétiques comprenant un réseau bidimensionnel de résonateurs en un premier matériau diélectrique ou magnéto diélectrique, lesdits résonateurs présentant une forme de calotte sphérique, ledit procédé comprenant une étape de fabrication additive pour la fabrication des résonateurs lesdites ondes électromagnétiques à absorber étant comprises entre 0.1 et 50 GHz.

Selon un mode de réalisation la résolution de l'étape de fabrication additive est choisie de manière à dégrader la forme de la calotte sphérique et la reproductibilité de ladite forme d'un résonateur à l'autre.

La description suivante présente plusieurs exemples de réalisation du dispositif de l'invention : ces exemples sont non limitatifs de la portée de l'invention. Ces exemples de réalisation présentent à la fois les caractéristiques essentielles de l'invention ainsi que des caractéristiques additionnelles liées aux modes de réalisation considérés.

L'invention sera mieux comprise et d'autres caractéristiques, buts et avantages de celle-ci apparaîtront au cours de la description détaillée qui va suivre et en regard des dessins annexés donnés à titre d'exemples non limitatifs et sur lesquels :

La figure 1 déjà citée illustre les paramètres électromagnétiques d'un matériau magnéto-diélectrique connu de l'état de l'art.

La figure 2 déjà citée décrit un matériau absorbant structuré connu de l'état de l'art.

La figure 3 illustre un résonateur en forme de calotte sphérique selon l'invention.

La figure 4 illustre la variation des paramètres électromagnétiques ($\varepsilon'$, $\varepsilon''$, $\mu'$, $\mu''$) mesurés d'une matrice polymère chargée par des particules magnétiques en fonction de la fréquence.

La figure 5 illustre différents modes de réalisation du dispositif selon l'invention.

La figure 6 illustre un dispositif d'absorption selon l'invention selon le deuxième mode de réalisation et comprenant des résonateurs hémisphériques.

La figure 7 illustre différentes incidences sur le résonateur selon l'invention en mode TE et TM.

La figure 8 illustre les dimensions du réseau des résonateurs cylindriques pour la simulation.

La figure 9 illustre les dimensions des réseaux de résonateurs hémisphériques pour la simulation.

La figure 10 illustre le niveau d'absorption de la structure cylindrique dite CR en fonction de l'angle d'incidence pour les deux modes (TE à gauche et TM à droite) du champ électromagnétique.

La figure 11 illustre le niveau d'absorption de la structure hémisphérique dite HR en fonction de l'angle d'incidence pour les deux modes (TE à gauche et TM à droite) du champ électromagnétique.

La figure 12 présente le rapport entre le niveau d'absorption A(HR) des résonateurs hémisphériques et le niveau d'absorption A(CR) des résonateurs cylindriques (TE à gauche et TM à droite) en fonction de la fréquence.

La figure 13 illustre les coefficients de réflexions des modes incidents TE00 (à gauche) et TM00 (à droite) de la structure 3D selon l'invention en fonction de la fréquence.

La figure 14 illustre un dispositif selon l'invention dont la structure en premier matériau est réalisée par fabrication additive sur une couche de deuxième matériau Sub.

**EP 4 142 449 B1**

## DESCRIPTION DETAILLEE DE L'INVENTION

Le dispositif d'absorption d'ondes électromagnétiques selon l'invention comprend un réseau bidimensionnel de résonateurs Res en un premier matériau diélectrique ou magnéto diélectrique Mat1, les résonateurs présentant une forme de calotte sphérique. On dénomme ce réseau bidimensionnel de résonateurs selon l'invention structure 3D.

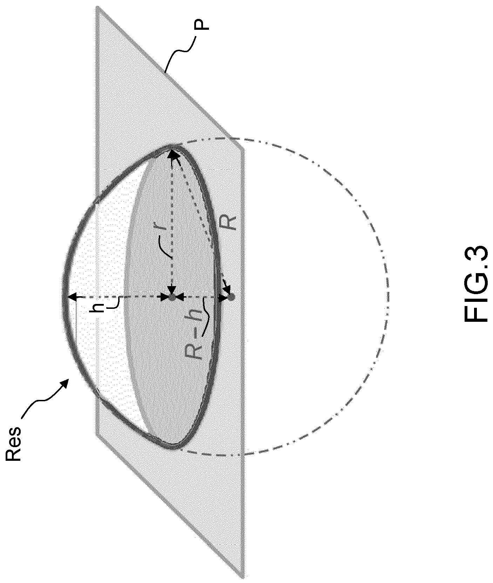

Un résonateur Res en forme de calotte sphérique est illustré figure 3. Une calotte sphérique est une portion de sphère délimitée par un plan P. La sphère a un rayon R et on dénomme h la hauteur de la calotte sphérique.

Les inventeurs ont montré après de nombreuses expériences et simulations que des résonateurs en forme de calotte sphérique présentaient des performances angulaires améliorées, comme montré plus loin. En effet les résonateurs Res tels que revendiqués absorbent les ondes incidentes de normales à rasantes sur une large bande de fréquence. La forme en calotte sphérique permet donc non seulement d'être insensible à la polarisation (en incidence normale et proche de la normale) mais également d'améliorer la robustesse angulaire, due à la convexité des résonateurs et à la dispersion en fréquence des matériaux diélectriques ou magnéto diélectriques

Les ondes électromagnétiques à absorber présentent une fréquence comprise entre 0.1 et 50 GHz, et plus particulièrement entre 2 et 18 GHz. Cette bande de fréquence [2 GHz ; 18 GHz] comprend la bande X (8-12 GHz) et la bande S (2-4 GHz).

Un matériau Mat1 particulièrement bien adapté à la réalisation d'un dispositif selon l'invention est une matrice thermoplastique chargée magnétiquement.

L'objectif est de réaliser des absorbants avec des thermoplastiques hautes performances par fabrication additive. La méthode la plus commune, dénommée FDM (pour Fused Deposition Modeling en anglais) utilise un fil fondu.

Or il est compliqué de synthétiser sous forme de filaments des matériaux avec de forts $\varepsilon$' et $\mu$' et de fortes pertes : les filaments sont difficilement bobinables (le bobinage est nécessaire à l'impression avec la méthode FDM) et bouchent la buse d'impression.

C'est pourquoi, on recherche un compromis entre des valeurs de paramètres électromagnétiques ($\varepsilon$', $\mu$') et de pertes ($\varepsilon$"/$\varepsilon$', $\mu$"/$\mu$') suffisamment élevées pour les raisons expliquées ci-dessus, mais pas trop pour que le matériau soit compatible avec l'impression 3D, typiquement FDM. On recherche également une température de transition vitreuse élevée (> 100°C).

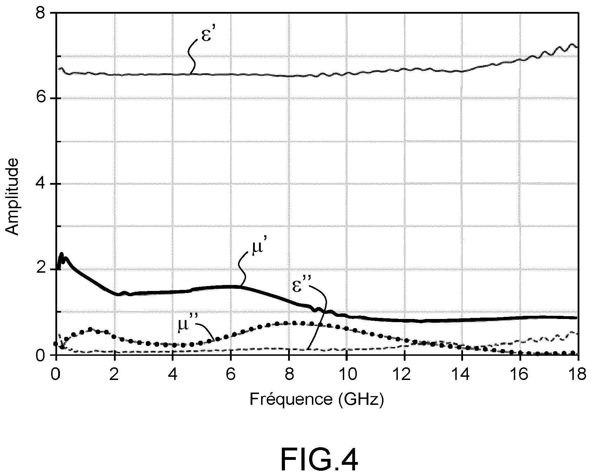

Les inventeurs ont identifié un matériau Mat1 satisfaisant ce compromis. Il s'agit d'une matrice de polymère COC (pour Cyclique Olefin Copolymer) chargée par des particules d'hexaferrite, de formule COC5-H10. La variation des paramètres électromagnétiques ($\varepsilon$', $\varepsilon$", $\mu$', $\mu$") mesurés d'une matrice polymère COC5-H10 en fonction de la fréquence est illustrée figure 4. Le COC5-H10 a une température de transition vitreuse élevée (134°C), compatible avec des environnements sévères (-50°C jusqu'à + 85°C).

Un matériau de ce type illustre ces valeurs de compromis, présente une permittivité $\varepsilon$' et une perméabilité $\mu$' élevées, ainsi que des pertes diélectriques $\varepsilon$"/$\varepsilon$' et magnétiques $\mu$"/$\mu$' élevées, mais ces valeurs sont moins élevées que celles du matériau de la figure 1.

A noter que l'évolution de la partie réelle de la permittivité $\varepsilon$' à partir de 10 GHz est peu fiable du fait des limitations du système de mesure. Il est en réalité peu probable que la permittivité augmente, elle est sans doute constante sur toute la bande.

On cherche à réaliser des dispositifs absorbant souples et/ou sur substrat souple, permettant de couvrir des surfaces non planes.

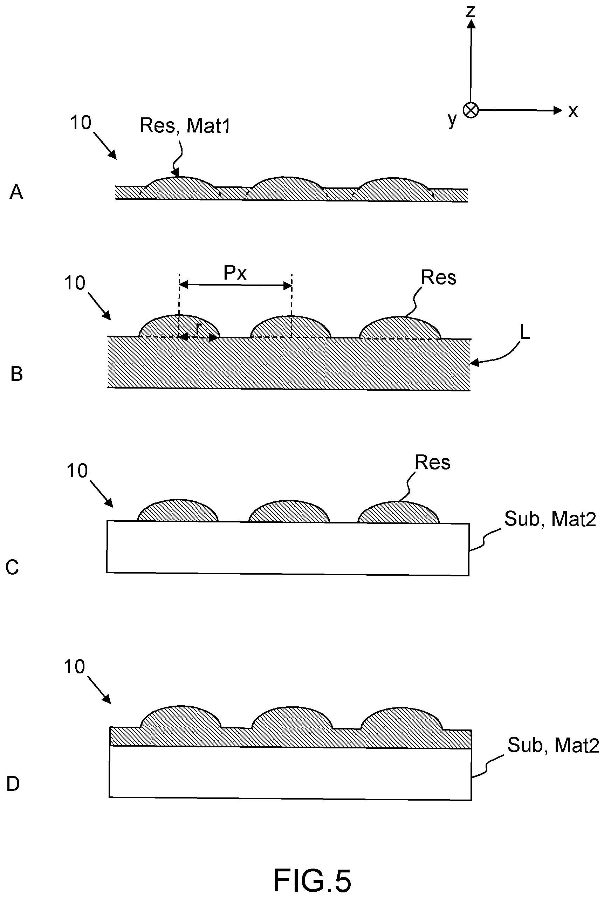

Différents modes de réalisation du dispositif 10 selon l'invention sont illustrés figure 5.

Selon un premier mode de réalisation les résonateurs Res sont reliés entre eux par une portion de couche (A) ou une couche L (B) en premier matériau Mat1.

Selon un deuxième mode de réalisation, compatible avec le premier mode de réalisation, les résonateurs Res sont disposés sur une couche Sub en deuxième matériau Mat2. Cela peut être uniquement les calottes sphériques, comme illustré en C ou les calottes reliées entre elles par une couche en matériau Mat 1 (premier mode de réalisation) comme illustré en D. Par exemple l'épaisseur de la couche L de Mat1 est de l'ordre de quelques millimètres.

Préférentiellement le deuxième matériau Mat2 est choisi parmi : un matériau métallique (plan de masse), un matériau diélectrique, un matériau magnéto diélectrique. Un matériau Mat2 permettant d'obtenir une amélioration de l'absorption à basse fréquence du dispositif 10 est un élastomère chargé magnétiquement.

Le dispositif 10 selon l'invention fonctionne avec ou sans plan de masse. Le plan de masse est un substrat métallique qui permet d'empêcher la transmission mais n'est pas responsable de l'absorption. C'est le réseau de résonateurs qui absorbe l'énergie incidente.

Les résonateurs sont répartis selon deux axes X et Y perpendiculaires entre eux.

Préférentiellement la périodicité selon X Px est égale à la périodicité selon Y Py, afin d'obtenir une insensibilité à la polarisation : Px=Py=P.

Préférentiellement on cherche à maximiser le taux de remplissage 2r/P, typiquement 2r/P $\geq$ 0.9.

En effet on souhaite minimiser la période P car pour les longueurs d'ondes $\lambda$ < P des phénomènes de diffraction apparaissent et réduisent l'absorption. Ainsi, la période limite la fréquence max (longueur d'onde min) de la bande de fréquence dans laquelle on absorbe. La périodicité dépend également des matériaux utilisés et du procédé de fabrication du dispositif selon l'invention. Préférentiellement pour une absorption dans la bande de fréquence [0.1 ; 50 GHz] la périodicité P est comprise entre 1 et 500 mm. Préférentiellement pour une absorption sur toute la bande de fréquence [2 ; 18 GHz] P est comprise entre 10 et 50 mm.

Le taux de remplissage définit les dimensions des résonateurs et donc de la fréquence de résonance du mode dominant, qui correspond à la fréquence min de la bande de fréquence dans laquelle on absorbe.

Ainsi pour maximiser la bande de fréquence, on veut réduire P et augmenter le taux de remplissage (ce qui nécessite de forts $\varepsilon$ et $\mu$).

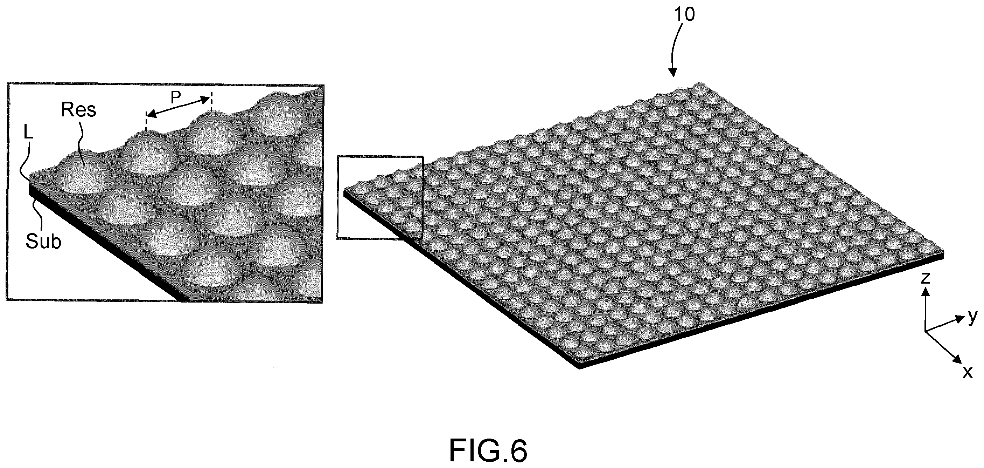

La figure 6 illustre un dispositif 10 d'absorption selon l'invention selon le deuxième mode de réalisation (figure 5 D) comprenant des résonateurs hémisphériques et avec Px=Py=P.

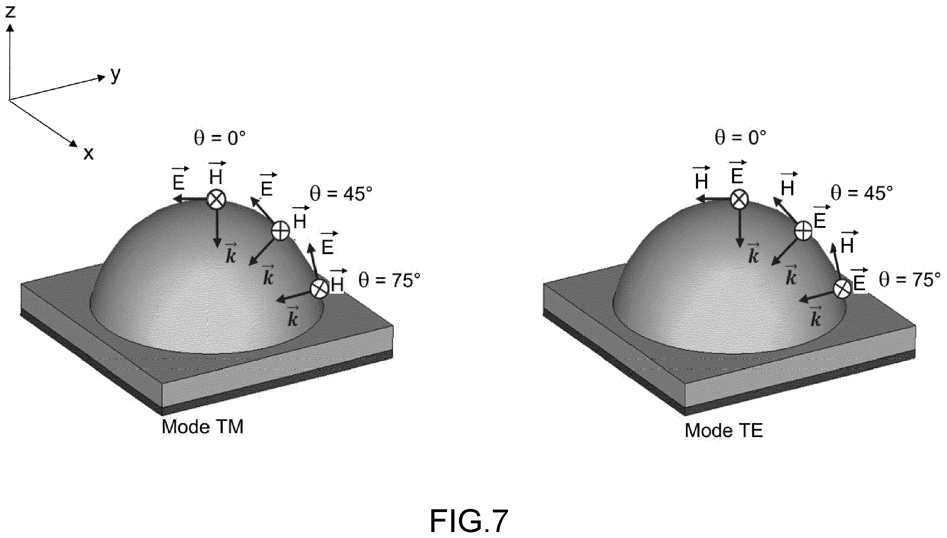

Les simulations ont montré que les meilleurs résultats sont obtenus pour une forme hémisphérique de résonateur, soit h=R. L'absorption des ondes incidentes rasantes, avec un angle d'élévation $\theta$ se rapprochant de 90° est améliorée grâce à la forme convexe des résonateurs. En effet les simulations ont montré que la forme convexe des résonateurs hémisphériques permet, pour des angles d'incidence normaux à rasants, d'induire le confinement du champ électromagnétique dans les résonateurs, surtout lorsque l'onde incidente arrive en mode TM. Différentes incidences sur le résonateur Res en mode TE et TM sont illustrées figure 7.

Les inventeurs ont déterminé que pour le résonateur selon l'invention le niveau d'absorption maximum s'obtient à la fréquence de résonance minimum $f_{rmin}$ de la bande de fréquence par l'excitation, dans le résonateur, du mode dominant par l'onde incidente.

La fréquence $f_{rmin}$ pour une demi-sphère est donnée par :

$$f_{rmin} = \frac{4.775 \cdot 10^7 Re(k_o R)}{\sqrt{\varepsilon.\mu}.R}$$

$R$ est le rayon du résonateur demi-sphérique, $k_o$ est le nombre d'onde dans le matériau, $\varepsilon$ est la permittivité du matériau Mat1 et $\mu$ est la perméabilité du matériau Mat1.

Cette expression est donnée pour un résonateur isolé mais en réalité, le couplage mutuel entre les résonateurs modifie légèrement la relation entre la fréquence de résonance et les dimensions des résonateurs (R et h le cas échéant).

Le choix du rayon R est lié au choix de la bande de fréquence d'absorption visée, la valeur de R déterminant la fréquence de résonance basse $f_{rmin}$ du résonateur (pour les propriétés électromagnétiques du matériau utilisé).

Dans le cas hémisphérique et pour un taux de remplissage élevé, on a P ~ 2.R.

Le niveau d'absorption maximale est obtenu à la fréquence de résonnance du mode dominant lorsque le facteur de qualité du résonateur $Q_0$ est équivalent au facteur de qualité radiatif Qrad de la structure 3D, qui dépend du couplage entre les résonateurs et qui augmente avec la période P et avec la permittivité $\varepsilon$ et la perméabilité $\mu$ du matériau, avec :

$$Q_o = \frac{1}{tan\delta_d} + \frac{1}{tan\delta_m} \qquad (1)$$

$tan\delta_d = \varepsilon"/\varepsilon'$        pertes diélectriques

$tan\delta_m = \mu"/\mu'$        pertes magnétiques

L'effet du couplage n'est pas modélisé analytiquement, Qrad est déterminé par simulation.

La fréquence du mode dominant du champ électromagnétique dans les résonateurs Res étant inversement proportionnelle aux propriétés magnéto-diélectriques du matériau Mat1, la dispersion en fréquence de ces propriétés permet la résonance du mode dominant sur une large bande de fréquence.

La dispersion en fréquence des propriétés des matrices thermoplastiques chargées magnétiquement est facilement obtenue dans le domaine des micro-ondes, dû aux phénomènes de relaxation.

L'ajout d'une couche Sub d'un matériau Mat2 sous la structure 3D, tel qu'illustré figure 5 C ou D et figure 6, permet de réduire les dimensions et d'améliorer l'absorption à basses fréquences de la structure 3D. Un matériau Mat 2 présentant cette propriété est une couche d'élastomère chargée magnétiquement.

L'ajout d'une couche de matériau Mat2 permet de jouer sur les propriétés effectives de la structure sans modifier la structuration :

- une couche non structurée n'est généralement pas suffisante pour absorber, notamment les incidences obliques, mais peut être réalisée facilement avec de bonnes propriétés de matériau,
- une couche structurée conforme ne peut pas être réalisée par impression avec n'importe quel matériau (propriétés limitées).

Ainsi la combinaison des deux types de couche permet d'avoir de meilleures performances.

Les inventeurs ont par ailleurs montré que les performances de l'absorbant à base de résonateurs hémisphériques (ou de calottes sphériques) sont supérieures à celles d'un absorbant à base de résonateurs cylindriques, lorsque le matériau Mat1 présente des valeurs de compromis au niveau des paramètres électromagnétiques. En d'autres termes l'absorbant hémisphérique est plus tolérant aux matériaux à plus faibles pertes. Ainsi par simulations il a été montré que les performances de l'absorbant hémisphérique restent très bonnes pour des matériaux présentant un niveau de perte $1/Q_0$ tel que :

$$1/Q_o \leq 0.05$$

pour des paramètres électromagnétiques aux fréquences comprises entre 2 et 18 GHz.

Ceci est en partie dû au niveau de couplage entre les résonateurs, plus faible pour les résonateurs hémisphériques que pour les résonateurs cylindriques.

A titre d'exemple le matériau COC5-H10 avec les paramètres électromagnétiques de la figure 4 présente un niveau de pertes $1/Q_0$ sur la bande 2-12 GHz compris entre 0.008 et 0.04 (0.02 en moyenne). Ces valeurs sont à comparer à celles du matériau de la figure 1 (composite de nylon et de poudre de fer carbonyle), qui est représentatif des meilleures valeurs de l'état de l'art en terme de permittivité, perméabilité et pertes élevées pour ce type d'application, et pour lequel les pertes $1/Q_0$ sur la bande 2-12 GHz varient de 0.09 à 0.14 et sont en moyenne de l'ordre de 0.1.

Pour mettre en évidence les avantages du dispositif 10 selon l'invention, ses performances sont comparées par simulation à celle d'un réseau cylindrique de l'état de l'art de dimensions similaires, avec un matériau Mat1 en COC5-H10 présentant les paramètres électromagnétiques de la figure 4.

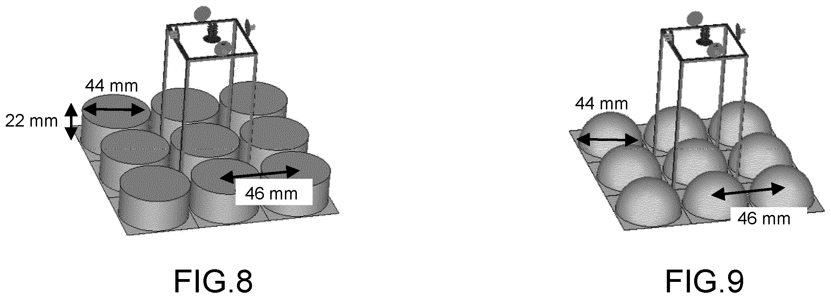

La figure 8 illustre les dimensions du réseau de résonateurs cylindriques, des cylindres de diamètre de 44 mm et de 22 mm de hauteur, séparés de P= 46 mm. La figure 9 illustre les dimensions du réseau de résonateurs hémisphériques de diamètre 44 mm et de même période P= 46 mm. Ainsi le rayon et la période des cylindres sont similaires au rayon et à la période des hémisphères. La hauteur des cylindres (22 mm) est également similaire à celle des hémisphères.

Les deux réseaux de résonateurs sont posés sur un plan métallique.

Les structures absorbantes des figures 8 et 9 sont modélisées et simulées avec le logiciel CST, avec les propriétés mesurées du COC5-H10 importées dans le logiciel. Une cellule unitaire composée d'un résonateur est simulée avec des conditions périodiques et un port de Floquet pour l'excitation de l'onde incidente (modes TE00 et TM00 à divers angles d'incidence). L'absorption est estimée grâce aux coefficients de réflexion sur le port d'excitation de 50 modes de Floquet pour prendre en compte les réflexions dans toutes les directions et pas seulement celle opposée à l'angle d'incidence. Le calcul est réalisé à 50 points de fréquences équidistants sur la bande 0.3 - 18 GHz, pour limiter le temps de simulation.

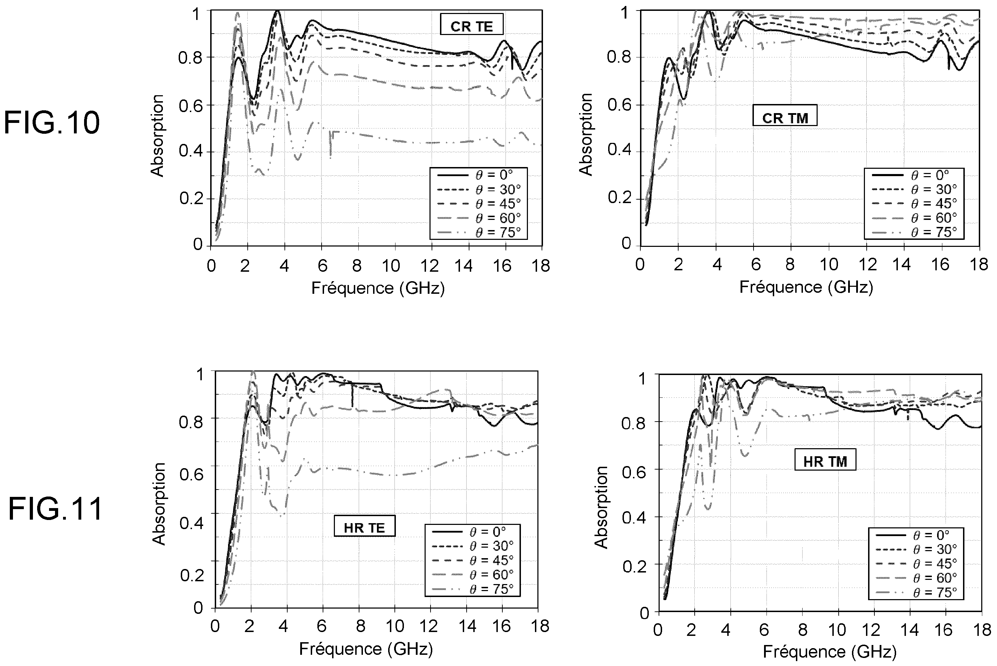

La figure 10 illustre le niveau d'absorption de la structure cylindrique dite CR en fonction de l'angle d'incidence pour les deux modes (TE à gauche et TM à droite) du champ électromagnétique.

La figure 11 illustre le niveau d'absorption de la structure hémisphérique dite HR en fonction de l'angle d'incidence pour les deux modes (TE à gauche et TM à droite) du champ électromagnétique.

Le volume des cylindres étant plus important que ceux des hémisphères pour des dimensions identiques, la fréquence minimum d'absorption est plus faible dans le cas des résonateurs cylindriques. Cependant, avec ces dimensions plus avantageuses pour les résonateurs cylindriques, on peut apprécier d'autant plus les bénéfices apportés par la forme hémisphérique en incidence oblique.

On observe, comme mentionné précédemment, que les résonateurs cylindriques ont un premier pic d'absorption à 1.45 GHz (fréquence de résonnance minimum) contre 2 GHz pour les hémisphères qui ont un volume plus faible.

Pour les deux types de résonateurs, le niveau d'absorption reste élevé pour les forts angles d'incidence pour le mode TM. Néanmoins, on peut voir que le niveau d'absorption est amélioré en incidence oblique avec les résonateurs hémisphériques, pour le mode TE (0.6 au lieu de 0.45 environ).

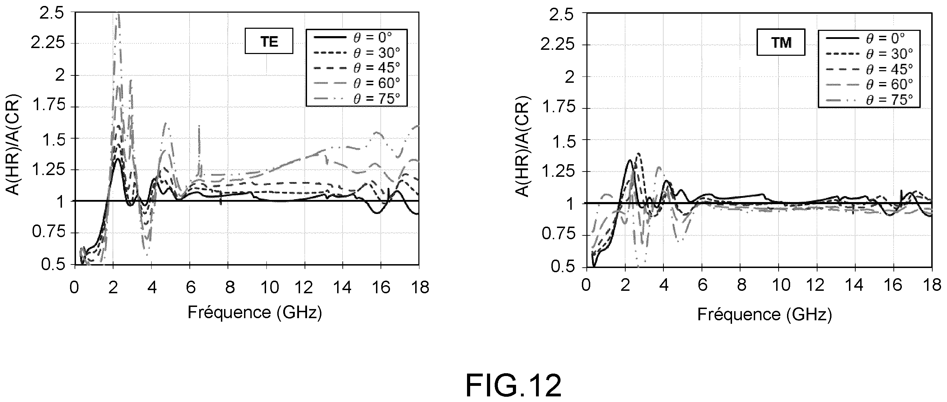

Pour mieux apprécier l'amélioration obtenue avec la structure 3D selon l'invention la figure 12 présente le rapport entre le niveau d'absorption A(HR) des résonateurs hémisphériques et le niveau d'absorption A(CR) des résonateurs cylindriques (TE à gauche et TM à droite) en fonction de la fréquence. Des valeurs supérieures à 1 signifient une meilleure performance des résonateurs hémisphériques.

Les fréquences de résonance des deux structures n'étant pas exactement les mêmes, les bénéfices d'une structure par rapport à une autre alternent à basse fréquence. En revanche, à partir de 6 GHz, on voit une nette amélioration du niveau d'absorption pour le mode TE au profit des résonateurs hémisphériques. Le rapport A(HR)/A(CR) est d'autant plus grand que l'angle d'incidence est proche de l'horizon : jusqu'à 1.5 pour un angle d'incidence de 75° pour les plus hautes fréquences.

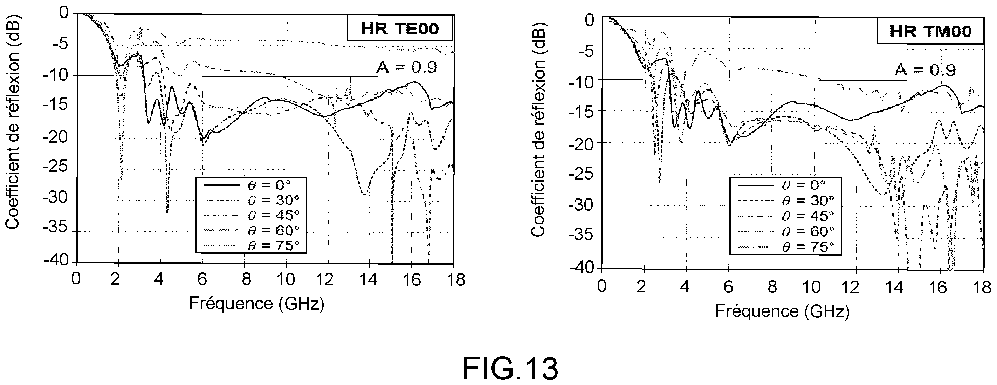

Afin de comparer la robustesse angulaire à l'état de l'art, les coefficients de réflexions des modes incidents TE00 (à gauche) et TM00 (à droite) de la structure 3D selon l'invention avec des résonateurs hémisphériques, en fonction de la fréquence, sont présentés sur la figure 13. La robustesse angulaire, définie par l'angle d'incidence maximum donnant une absorption supérieure à 90%, est de 45° (TE) et 60° (TM) sur la bande 4-18 GHz et de 60° (TE) et 75° (TM) sur la bande 10-18 GHz. A titre comparatif des valeurs de robustesse de 60° et 45° sur une bande 6-18 GHz sont décrites dans la publication K.L. Zhang « Multifunctionnal broadband microwave absorption of flexible graphene composites », Carbon, vol 141, p 608-617, 2019.

On constate bien qu'à dimensions équivalentes, et avec un matériau Mat1 présentant des valeurs de paramètres électromagnétiques de compromis (ni trop importantes pour permettre une impression 3D, ni trop faibles pour obtenir de bonnes propriétés d'absorption), les résonateurs de forme hémisphérique sont plus performants que leur équivalent cylindrique.

Selon un autre l'aspect l'invention concerne un procédé de fabrication du dispositif d'absorption 10 selon l'invention. Les résonateurs peuvent être fabriqués par moulage. Selon un autre mode de réalisation préféré le procédé comprend une étape de fabrication additive. Deux exemples sont les technologies SLS et FDM citées précédemment. Ces technologies présentent en effet de nombreux avantages (coût, précision, réalisation de structures conformes aux surfaces à couvrir). La contrainte est l'utilisation d'un matériau présentant les bonnes propriétés diélectrique/magnétique, imprimable et avec une forte tenue thermo-mécanique.

La technologie FDM est en outre particulièrement bien adaptée à la réalisation de résonateurs hémisphériques pour les raisons suivantes.

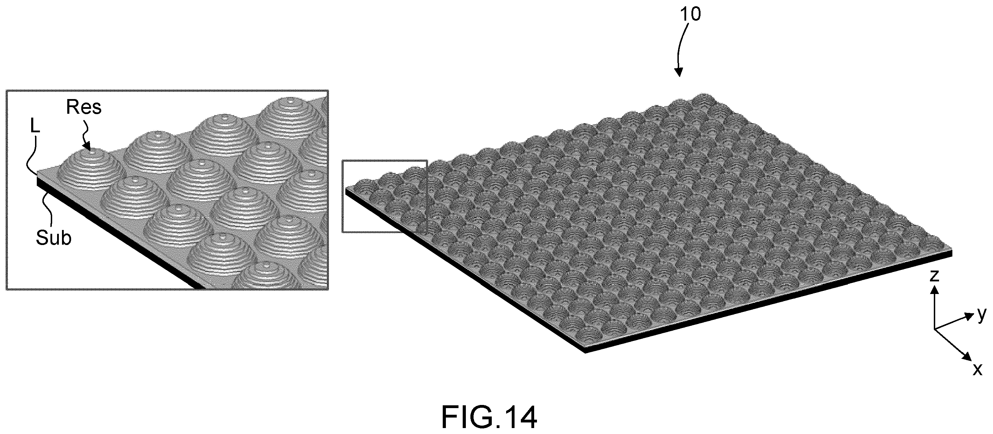

Une forme hémisphérique est facilement réalisable par discrétisation en un empilement de fines couches cylindriques. Un dispositif 10 selon l'invention dont la structure en premier matériau est réalisée par fabrication additive sur une couche de deuxième matériau Sub est illustré figure 14.

Le temps de fabrication peut être réduit grâce au réglage de la résolution de l'impression 3D, qui permet de réaliser facilement des gradients d'épaisseur (qui peuvent être aussi lissés par recuit).

De plus préférentiellement la résolution est choisie de manière à dégrader la forme de la calotte sphérique et la reproductibilité de ladite forme d'un résonateur à l'autre. Cette diminution de résolution est par exemple obtenue en augmentant le diamètre des buses du système de fabrication additive.

Ces imperfections d'une l'impression 3D « dégradée » permettent de casser la périodicité stricte des résonateurs et ainsi de lisser le niveau d'absorption sur la bande de fréquence d'intérêt en moyennant les différentes résonnances. En effet la résonance étant liée à l'équivalence entre le facteur de qualité du matériau et le facteur de qualité radiatif, qui lui-même dépendent de la périodicité des résonateurs, la fréquence de résonance peut varier en faisant varier la période. Ainsi, en cassant la périodicité stricte de la structure, plusieurs résonances peuvent se superposer sur la bande de fréquence d'intérêt. Cela permet, par effet de moyenne, de lisser le niveau d'absorption.

## Revendications

1. Dispositif (10) d'absorption d'ondes électromagnétiques présentant une fréquence comprise entre 0.1 et 50 GHz, le dispositif d'absorption comprenant un réseau bidimensionnel de résonateurs (Res) en un premier matériau diélectrique ou magnéto diélectrique (Mat1), et étant **caractérisé en ce que** lesdits résonateurs présentent une forme de calotte sphérique.

2. Dispositif selon la revendication 1 dans lequel le réseau bidimensionnel est selon deux axes X et Y perpendiculaires entre eux et la périodicité selon X est égale à la périodicité selon Y.

3. Dispositif selon l'une des revendications précédentes dans lequel le premier matériau (Mat1) est une matrice thermoplastique chargée magnétiquement.

4. Dispositif selon l'une des revendications précédentes dans lequel le premier matériau présente un niveau de perte $1/Q_0$ inférieur ou égal à 0.05, pour une bande de fréquence [2 GHz; 18 GHz], avec :

$$Q_o = \frac{1}{tan\delta_d} + \frac{1}{tan\delta_m}$$

$tan\delta_d = \varepsilon''/\varepsilon'$     pertes diélectriques

$tan\delta_m = \mu''/\mu'$     pertes magnétiques

$\varepsilon = \varepsilon' + i\varepsilon''$     $\varepsilon$ permittivité du premier matériau

$\mu = \mu' + i\mu''$     $\mu$ perméabilité du premier matériau

**5.** Dispositif selon l'une des revendications précédentes dans lequel les ondes électromagnétiques à absorber sont comprises dans la bande [2 GHz ; 18 GHz].

**6.** Dispositif selon l'une des revendications précédentes dans lequel la calotte sphérique est un hémisphère.

**7.** Dispositif selon l'une des revendications précédentes dans lequel les résonateurs sont reliés entre eux par une portion de couche ou une couche en premier matériau.

**8.** Dispositif selon l'une des revendications précédentes dans lequel les résonateurs sont disposés sur une couche (Sub) en deuxième matériau (Mat2).

**9.** Dispositif selon la revendication précédente dans lequel le deuxième matériau (Mat2) est choisi parmi : un matériau métallique, un matériau diélectrique, un matériau magnéto diélectrique.

**10.** Dispositif selon l'une des revendications 8 ou 9 dans lequel le deuxième matériau est un élastomère chargé magnétiquement.

**11.** Procédé de fabrication d'un dispositif d'absorption d'ondes électromagnétiques comprenant un réseau bidimensionnel de résonateurs (Res) en un premier matériau diélectrique ou magnéto diélectrique (Mat1), lesdits résonateurs présentant une forme de calotte sphérique, ledit procédé comprenant une étape de fabrication additive pour la fabrication des résonateurs, lesdites ondes électromagnétiques à absorber étant comprises entre 0.1 et 50 GHz.

**12.** Procédé selon la revendication précédente dans lequel la résolution de l'étape de fabrication additive est choisie de manière à dégrader la forme de la calotte sphérique et la reproductibilité de ladite forme d'un résonateur à l'autre.

**Patentansprüche**

**1.** Vorrichtung (10) zur Absorption von elektromagnetischen Wellen mit einer Frequenz zwischen 0,1 und 50 GHz, wobei die Absorptionsvorrichtung ein zweidimensionales Netz von Resonatoren (Res) aus einem ersten dielektrischen oder magnetisch-dielektrischen Material (Mat1) umfasst und **dadurch gekennzeichnet ist, dass** die Resonatoren eine kugelförmige Kuppelform aufweisen.

**2.** Vorrichtung nach Anspruch 1, wobei das zweidimensionale Netz entlang zwei Achsen X und Y senkrecht zueinander verläuft und die Periodik entlang X gleich der Periodik entlang Y ist.

**3.** Vorrichtung nach einem der vorhergehenden Ansprüche, wobei das erste Material (Mat1) eine magnetisch geladene thermoplastische Matrix ist.

**4.** Vorrichtung nach einem der vorhergehenden Ansprüche, wobei das erste Material einen Verlustpegel $1/Q_0$ kleiner oder gleich 0,05 für einen Frequenzbereich [2 GHz; 18 GHz] aufweist, wobei:

$$Q_o = \frac{1}{tan\delta_d} + \frac{1}{tan\delta_m}$$

$tan\delta_d = \varepsilon''/\varepsilon'$ dielektrische Verluste

$tan\delta_m = \mu'/\mu'$ magnetische Verluste

$\varepsilon = \varepsilon^x + i\varepsilon''$ $\varepsilon$ Permittivität des ersten Materials

$\mu = \mu' + i\mu''$ μ Durchlässigkeit des ersten Materials

**5.** Vorrichtung nach einem der vorhergehenden Ansprüche, wobei die zu absorbierenden elektromagnetischen Wellen im Bereich [2 GHz; 18 GHz] enthalten sind.

**6.** Vorrichtung nach einem der vorhergehenden Ansprüche, wobei die kugelförmige Kuppel eine Halbkugel ist.

**7.** Vorrichtung nach einem der vorhergehenden Ansprüche, wobei die Resonatoren durch einen Schichtabschnitt oder eine Schicht aus dem ersten Material miteinander verbunden sind.

**8.** Vorrichtung nach einem der vorhergehenden Ansprüche, wobei die Resonatoren auf einer Schicht (Sub) aus dem zweiten Material (Mat2) angeordnet sind.

**9.** Vorrichtung nach dem vorhergehenden Anspruch, wobei das zweite Material (Mat2) ausgewählt ist aus einem metallischen Material, einem dielektrischen Material, einem magnetisch-dielektrischen Material.

**10.** Vorrichtung nach einem der Ansprüche 8 oder 9, wobei das zweite Material ein magnetisch geladenes Elastomer ist.

**11.** Verfahren zum Herstellen einer Vorrichtung zur Absorption von elektromagnetischen Wellen, umfassend ein zweidimensionales Netz von Resonatoren (Res) aus einem ersten dielektrischen oder magnetisch-dielektrischen Material (Mat1), wobei die Resonatoren eine kugelförmige Kuppelform aufweisen, wobei das Verfahren einen Schritt zur additiven Herstellung für die Herstellung der Resonatoren umfasst, wobei die zu absorbierenden elektromagnetischen Wellen zwischen 0,1 und 50 GHz liegen.

**12.** Verfahren nach dem vorhergehenden Anspruch, wobei die Auflösung des Schritts zur additiven Herstellung so ausgewählt wird, dass die Form der kugelförmigen Kuppel und die Reproduzierbarkeit der Form von einem Resonator zum nächsten herabgesetzt wird.

## Claims

**1.** A device (10) for absorbing electromagnetic waves having a frequency ranging between 0.1 and 50 GHz, the absorption device comprising a two-dimensional array of resonators (Res) made of a first dielectric or magneto-dielectric material (Mat1), and being **characterised in that** said resonators are in the shape of a spherical cap.

**2.** The device according to claim 1, wherein the two-dimensional array is along two X and Y axes perpendicular to each other and the periodicity along X is equal to the periodicity along Y.

**3.** The device according to any of the preceding claims, wherein the first material (Mat1) is a magnetically charged thermoplastic matrix.

**4.** The device according to one of the preceding claims, wherein the first material has a loss level $1/Q_0$ that is less than or equal to 0.05, for a [2 GHz; 18 GHz] frequency band, with:

$$Q_o = \frac{1}{tan\delta_d} + \frac{1}{tan\delta_m}$$

$tan\delta_d = \varepsilon''/\varepsilon'$ dielectric losses;
$tan\delta_m = \mu''/\mu'$ magnetic losses;
$\varepsilon = \varepsilon' + i\varepsilon''$ ε permittivity of the first material;
$\mu = \mu' + i\mu''$ μ permeability of the first material.

**5.** The device according to one of the preceding claims, wherein the electromagnetic waves to be absorbed are within the [2 GHz; 18 GHz] band.

**6.** The device according to one of the preceding claims, wherein the spherical cap is a hemisphere.

7. The device according to one of the preceding claims, wherein the resonators are connected to each other by a layer portion or a layer of first material.

8. The device according to one of the preceding claims, wherein the resonators are arranged on a layer (Sub) of second material (Mat2).

9. The device according to the preceding claim, wherein the second material (Mat2) is selected from among: a metal material, a dielectric material, a magneto-dielectric material.

10. The device according to any of claims 8 or 9, wherein the second material is a magnetically charged elastomer.

11. A method for manufacturing a device for absorbing electromagnetic waves comprising a two-dimensional array of resonators (Res) made of a first dielectric or magneto-dielectric material (Mat1), said resonators being in the shape of a spherical cap, said method comprising an additive manufacturing step for manufacturing the resonators, said electromagnetic waves to be absorbed ranging between 0.1 and 50 GHz.

12. The method according to the preceding claim, wherein the resolution of the additive manufacturing step is selected so as to degrade the shape of the spherical cap and the reproducibility of said shape from one resonator to the next.

FIG.1

A

B

FIG.2

EP 4 142 449 B1

FIG.3

EP 4 142 449 B1

FIG.4

**FIG.5**

FIG.6

EP 4 142 449 B1

FIG.7

FIG.9

FIG.8

FIG.10

FIG.11

FIG.12

FIG.13

EP 4 142 449 B1

FIG.14

EP 4 142 449 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CN 111403536

**Littérature non-brevet citée dans la description**

- **D. ZHOU et al.** Analysis and Design of Multilayered Broadband Radar Absorbing Metamaterial Using the 3-D Printing Technology-Based Method. *IEEE Antennas and Wireless Propagation Letters*, 2017, vol. 16, 133-136

- **J. REN et al.** 3D-Printed Low-Cost Dielectric-Resonator-Based Ultra-Broadband Microwave Absorber Using Carbon-Loaded Acrylonitrile Butadiene Styrene Polymer. *Materials*, 2018, vol. 11 (1249)
- **K.L. ZHANG**. Multifunctionnal broadband microwave absorption of flexible graphene composites. *Carbon*, 2019, vol. 141, 608-617